# EUROPEAN PATENT APPLICATION

(11) **EP 4 700 160 A1**
(43) Date of publication of application: **25.02.2026**
(21) Application number: 25183922.1
(22) Date of filing: 19.06.2025
(51) Int. Cl.: C30B 19/12, C30B 9/12, C30B 19/02, C30B 29/10

(54) **RUBIDIUM FLUORO-SCANDIUM BORAT COMPOUND, RUBIDIUM FLUORO-SCANDIUM BORATE NONLINEAR OPTICAL CRYSTAL AND PREPARATION METHODS AND APPLICATIONS THEREOF**

(30) Priority: 21.08.2024 CN 202411150219
(71) Applicant: The Xinjiang Technical Institute Of Physics & Chemistry, Chinese Academy of Sciences, Urumqi, Xinjiang 830011 (CN)
(72) Inventor: PAN, Shilie, Xinjiang, 830011 (CN); YANG, Yun, Xinjiang, 830011 (CN); LONG, Xifa, Xinjiang, 830011 (CN); ZHANG, Qianzhen, Xinjiang, 830011 (CN)
(74) Representative: Bryn Aarflot AS

(57) **Abstract**

The present invention relates to a rubidium fluoro-scandium borate compound, a rubidium fluoro-scandium borate nonlinear optical crystal, and a preparation method and application thereof. The rubidium fluoro-scandium borate compound has a chemical formula Rb₂ScB₃O₆F₂, does not contain a symmetry center and has a molecular weight of 382.33 g/mol. The rubidium fluoro-scandium borate nonlinear optical crystal belongs to the monoclinic crystal system, and belongs to the non-centrosymmetric space group *P*2₁, and the unit cell parameters are: *a =* 4.0372(10) Å, *b* = 11.800(3) Å, *c* = 8.823(2) Å, *α = γ =* 90°, *β* = 98.327(11) °, *Z* = 2. The present invention adopts a high-temperature vacuum packaging method or a solid-state synthesis method to prepare rubidium fluoro-scandium borate compounds. The present invention adopts a fluxing agent method to prepare a rubidium fluoro-scandium borate nonlinear optical crystal, which have the advantages of short absorption cutoff edge, large nonlinear optical effect, good thermal stability, and stable physical and chemical properties. The rubidium fluoro-scandium borate nonlinear optical crystal of the present invention can be used to fabricate nonlinear optical devices, which have important applications in fields such as optics, military, laser lithography, and communication, etc..

## Description

### TECHNICAL FIELD OF THE INVENTION

The present invention belongs to the field of nonlinear optical crystals, particularly, relating to a rubidium fluoro-scandium borate (Rb₂ScB₃O₆F₂) compound, a Rb₂ScB₃O₆F₂ nonlinear optical crystal, as well as their preparation methods and applications.

### BACKGROUND OF THE INVENTION

The emergence of lasers has aroused great interest in the research and application of laser technology. The lasers generated by a laser device can be frequency converted through nonlinear optical devices to obtain more lasers with useful wavelengths, which have important applications in expanding frequencies of a laser device, ultra short/ultra strong laser pulses, optical communication, and other fields. Nonlinear optical crystal materials, as an important component of all-solid-state laser device, play an important role in the field of modern laser science. Depending on the working band, nonlinear optical crystal materials are divided into the materials involving four bands: deep-ultraviolet band (<200 nm), ultraviolet band (200-400 nm), visible/near-infrared band (0.4-3 µm), and mid/far-infrared band (including 3-5 and 8-13 µm atmospheric transparent windows). Among them, deep-ultraviolet nonlinear optical crystal materials play a critical role in laser frequency conversion, ultrahigh-resolution lithography, and high-precision microfabrication.

According to the anionic group theory, the properties of materials are determined by the anionic groups. The functional groups such as [BO₂], [BO₃], [B₃O₆], etc. with a planar configuration exhibit larger polarization anisotropy and hyperpolarization, which is advantageous for obtaining larger birefringence and frequency doubling effects. Among them, as the functional group of the most excellent commercial crystal *β*-BaB₂O₄ (*β*-BBO), the group [B₃O₆] is considered one of the best functional groups for designing and synthesizing UV and DUV nonlinear optical crystals. The *β*-BBO crystal exhibits a high frequency doubling effect about 5.6 times that of KH₂PO₄ (KDP) and a large birefringence 0.12at 1064 nm. However, due to the insufficient short cutoff edge and large dispersion caused by heavier cation, *β*-BBO cannot use direct frequency doubling to output deep ultraviolet laser. Therefore, it is urgent to develop nonlinear optical crystal materials that have excellent nonlinear optical properties and can output deep ultraviolet frequency doubling light.

### SUMMARY OF THE INVENTION

An object of the present invention is to provide a novel compound capable of producing nonlinear optical crystals.

Another object of the present invention is to provide a method for preparing the above-mentioned novel compound.

A further object of the present invention is to provide a novel nonlinear optical crystal.

Another object of the present invention is to provide a method for preparing the above-mentioned nonlinear optical crystal.

Another object of the present invention is to provide the use of the above-mentioned nonlinear optical crystal.

The present invention provides a rubidium fluoro-scandium borate compound, with a chemical formula Rb₂ScB₃O₆F₂ and a molecular weight of 382.33 g/mol.

The present invention provides a method for preparing a rubidium fluoro-scandium borate compound, which adopts a high-temperature vacuum packaging method or a solid-state synthesis method.

In an embodiment, the method for preparing a rubidium fluoro-scandium borate compound adopting a high-temperature vacuum packaging method comprises the following steps:
Placing Rb source material, Sc source material, and B source material in a molar ratio of Rb:Sc:B = 2:1:3-5 in a graphite crucible, wherein the Rb source material is RbF, Rb₂CO₃, RbNO₃ or RbBF₄, the Sc source material is Sc₂O₃, ScF₃ or Sc(NO₃)₃, the B source material is B₂O₃, and at least one of the source materials is fluoride;
Placing the graphite crucible in a quartz tube, evacuating the quartz tube to a vacuum degree of 10⁻³ Pa, sealing the quartz tube at high temperature and then placing it in a muffle furnace; Heating the muffle furnace at a rate of 20°C/h to 650-680°C and maintaining the temperature for 28-33 hours, then cooling it at a rate of 1°C/h to 400-520°C, and finally cooling it to room temperature within 2-3 days to obtain the rubidium fluoro-scandium borate compound of the present invention.

In an embodiment, the method for preparing a rubidium fluoro-scandium borate compound adopting a solid-state synthesis method comprises the following steps:
Placing Rb source material, Sc source material, and B source material in a molar ratio of Rb:Sc:B = 2:1:3 in a corundum mortar, wherein the Rb source material is RbF, Rb₂CO₃, RbNO₃ or RbBF₄, the Sc source material is Sc₂O₃, ScF₃ or Sc(NO₃)₃, the B source material is B₂O₃ or H₃BO₃, and at least one of the source materials is fluoride; Grinding them to mix uniformly, and then pressing them into a sheet-like sample with a diameter of 2 cm through a die;
Placing the sample in a corundum crucible with a diameter of 5-10 cm, and placing the corundum crucible in a program-controlled single crystal growth furnace, heating it at a rate of 20-28°C/h to 650-670°C for solid-state reaction and maintaining the temperature for 3-5 days, and during the days, taking out the corundum crucible and grinding the sample 3-4 times for half an hour each time, followed by powder XRD testing, until the measured powder XRD is consistent with its theoretical value, placing the sample in the single crystal growth furnace at 650-670°C for 4-10 days, and finally cooling it to room temperature at a rate of 20°C/day to obtain the rubidium fluoro-scandium borate compound of the present invention.

In the present invention, during preparing Rb₂ScB₃O₆F₂ compound (polycrystalline powder) using a solid-state synthesis method, the following chemical reactions occur, including but not limited to:

(1) 2RbF+0.5Sc₂O₃+1.5B₂O₃=Rb₂ScB₃O₆F₂

(2) RbF+RbBF₄+0.5Sc₂O₃+1.5B₂O₃=Rb₂ScB₃O₆F₂+BF₃↑

(3) 2RbF+ScF₃+2B₂O₃=Rb₂ScB₃O₆F₂+BF₃↑

(4) 2RbF+Sc(NO₃)₃+3H₃BO₃=Rb₂ScB₃O₆F₂+3NO₂↑+4.5H₂O↑+0.75O₂↑

(5) 4RbNO₃+2ScF₃+6H₃BO₃=2Rb₂ScB₃O₆F₂+F₂↑+9H₂O↑+4NO₂↑+0.5O₂↑

(6) Rb₂CO₃+ScF₃+3H₃BO₃=Rb₂ScB₃O₆F₂+HF↑+4H₂O↑+CO₂↑

The present invention provides a rubidium fluoro-scandium borate nonlinear optical crystal, characterized in that the crystal belongs to the monoclinic crystal system, and belongs to the non-centrosymmetric space group *P*2₁, and the unit cell parameters are: *a* = 4.0372(10) Å, *b =* 11.800(3) Å, *c* = 8.823(2) A, *α* = *γ* = 90°, *β* = 98.327(11) °, *Z* = 2.

The present invention provides a method for preparing a rubidium fluoro-scandium borate nonlinear optical crystal, which adopts a fluxing agent method.

In an embodiment, the method for preparing a rubidium fluoro-scandium borate nonlinear optical crystal adopting a fluxing agent method comprises the following steps:
a. Adding the rubidium fluoro-scandium borate compound prepared by a solid-state synthesis method to a fluxing agent and placing them in an open platinum crucible with a diameter of 40 mm × 50 mm, then placing the platinum crucible in a program-controlled single crystal growth furnace, heating it at a rate of 50°C/h to 780-850°C and maintaining the temperature for 24-42 hours, then cooling it at a rate of 1-2°C/h to 730-780°C to obtain a mixed melt, wherein the fluxing agent is PbO, LiF, or PbF₂+PbO;
b. Obtaining seed crystals by cooling the mixed melt obtained in step *a* to room temperature at a rate of 0.5-3 °C/h;
c. Fixing the seed crystal obtained in step b onto a seed crystal rod, feeding the seed crystal from the top of the single crystal growth furnace to make it contact with the surface of the mixed melt obtained from the step *a* and leaving it at 730-780°C for 10 mins; then cooling the mixed melt to 700-710°C at a rate of 0.5-1°C/h and rotating the seed crystal rod at a speed of 5-7 rpm; taking out a crystal from the surface of the mixed melt when the crystal grows to the desired size, cooling it to room temperature at a rate of 20°C/h; finally taking out the crystal from the single crystal growth furnace to obtain a rubidium fluoro-scandium borate nonlinear optical crystal.

In an embodiment, in the method for preparing a rubidium fluoro-scandium borate nonlinear optical crystal adopting a fluxing agent method, the step *a* may be:
Adding Rb source material, Sc source material, and B source material to a fluxing agent and placing them in an open platinum crucible with a diameter of 40 mm × 50 mm, placing the platinum crucible in a program-controlled single crystal growth furnace, heating it at a rate of 50°C /h to 780-850°C and maintaining the temperature for 24-42 hours, then cooling it at a rate of 1-2°C/h to 730-780°C to obtain a mixed melt;
wherein the molar ratio of the Rb source material, the Sc source material, and B source material is = 2:1:3; wherein the Rb source material is RbF, Rb₂CO₃, or RbBF₄, the Sc source material is Sc₂O₃, or ScF₃, the B source material is B₂O₃ or H₃BO₃, and at least one of the source materials is fluoride;
wherein the fluxing agent is PbO, or PbF₂+PbO.

In an embodiment, the method for preparing a rubidium fluoro-scandium borate nonlinear optical crystal adopting a fluxing agent method may comprise the following steps:
Adding the rubidium fluoro-scandium borate compound prepared by a solid-state synthesis method to a fluxing agent and placing them in a platinum crucible with flanged seal with a diameter of 20 mm × 50 mm, then placing the platinum crucible in a program-controlled single crystal growth furnace, heating it at a rate of 5-20°C/h to 680-720°C and maintaining the temperature for 72 hours, then cooling it at a rate of 20°C/day to 400-480°C and futher cooling it to room temperature within 1-2 days to obtain a Rb₂ScB₃O₆F₂ nonlinear optical crystal;
wherein the fluxing agent is RbCl+CsF, or RbF+RbCl.

In an embodiment, the method for preparing a rubidium fluoro-scandium borate nonlinear optical crystal adopting a fluxing agent method may comprise the following steps:
Adding Rb source material, Sc source material, and B source material to a fluxing agent and placing them in a platinum crucible with flanged seal with a diameter of 20 mm × 50 mm, then placing the platinum crucible in a program-controlled single crystal growth furnace, heating it at a rate of 5-20°C/h to 680-720°C and maintaining the temperature for 72 hours, then cooling it at a rate of 20°C/day to 400-480°C and futher cooling it to room temperature within 1-2 days to obtain a Rb₂ScB₃O₆F₂ nonlinear optical crystal;
wherein the molar ratio of the Rb source material, the Sc source material, and B source material is = 2:1:3; wherein the Rb source material is RbF, or RbNO₃, the Sc source material is Sc₂O₃, ScF₃ or Sc(NO₃)₃, the B source material is B₂O₃, and at least one of the source materials is fluoride;
wherein the fluxing agent is MoO₃ or RbF+ PbO.

The rubidium fluoro-scandium borate (Rb₂ScB₃O₆F₂) nonlinear optical crystal of the present invention may be used in frequency doubling generator, up/down frequency converter, and optical parametric oscillator.

The size of the rubidium fluoro-scandium borate nonlinear optical crystal obtained by the method of the present invention is in the millimeter range. By using a larger-sized crucible and extending the growth period, the corresponding larger-sized Rb₂ScB₃O₆F₂ nonlinear optical crystal can be further obtained.

The crystal blank is oriented depending on the crystallographic data of the rubidium fluoro-scandium borate nonlinear optical crystal prepared by the present invention; then the crystal is cut depending on the required angle, thickness, and cross-sectional size; and after polishing the transparent surface of the crystal, the crystal can be used as a nonlinear optical device.

That is, at least one output radiation with a frequency different from the incident electromagnetic radiation can be generated by passing at least one incident electromagnetic radiation through at least one piece of Rb₂ScB₃O₆F₂ nonlinear optical crystal.

The rubidium fluoro-scandium borate nonlinear optical crystal of the present invention has the following beneficial effects:
(1) The Rb₂ScB₃O₆F₂ nonlinear optical crystal of the present invention has excellent optical properties, with a minimum optical transmittance of less than 175 nm and a larger nonlinear optical effect of 1.4 × KDP, which is type-I phase-matching; The birefringence calculated is 0.088 at 1064 nm, and the shortest wavelength for type-I phase-matching is 182 nm, which is expected to be used in the frequency doubling conversion process in the deep ultraviolet region;
(2) The Rb₂ScB₃O₆F₂ nonlinear optical crystal of the present invention is transparent and nonencapsulated during the growth process, with a fast growth rate;
(3) The Rb₂ScB₃O₆F₂ nonlinear optical crystal of the present invention can be used to fabricate nonlinear optical devices;
(4) The Rb₂ScB₃O₆F₂ nonlinear optical crystal of the present invention has important applications in fields such as optics, military, laser lithography, communication, etc..

### BRIEF DESCRIPTION OF THE DRAWINGS

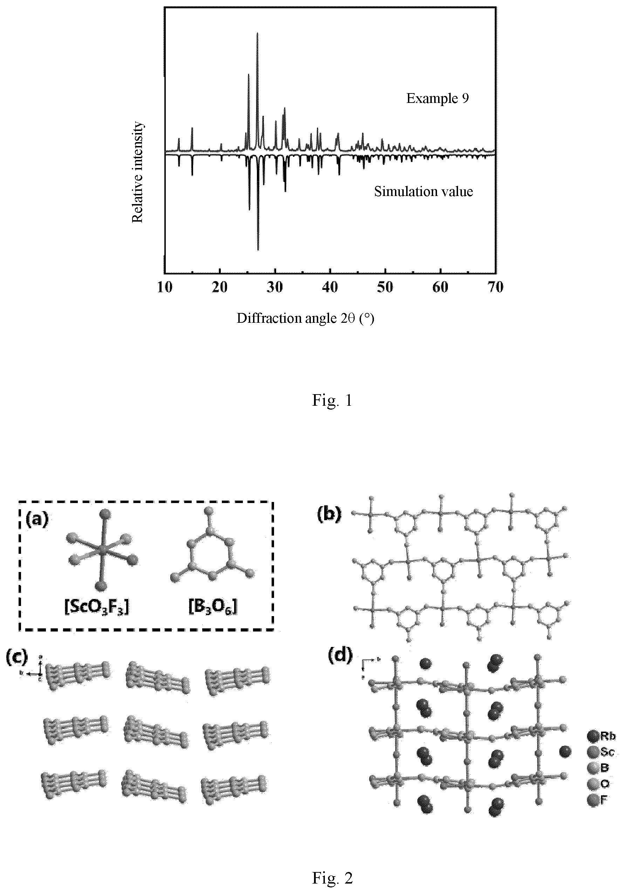

Fig. 1 shows the XRD pattern of the polycrystalline powder Rb₂ScB₃O₆F₂ obtained in Example 9 of the present invention, as well as the simulated XRD pattern based on the crystal structure of Rb₂ScB₃O₆F₂.
Fig. 2 is a schematic diagram of the structure of the Rb₂ScB₃O₆F₂ nonlinear optical crystal of the present invention, in which (a) the basic building groups, (b) the connection between the groups [ScO₃F₃] and [B₃O₆], (c) the arrangement of the groups [B₃O₆] observed from the c-axis, and (d) the overall structure of Rb₂ScB₃O₆F₂ observed from the c-axis, isolated groups [B₃O₆] are connected through the polyhedral of [ScO₃F₃], and Rb atoms fill the pores to balance charges and support the structure.

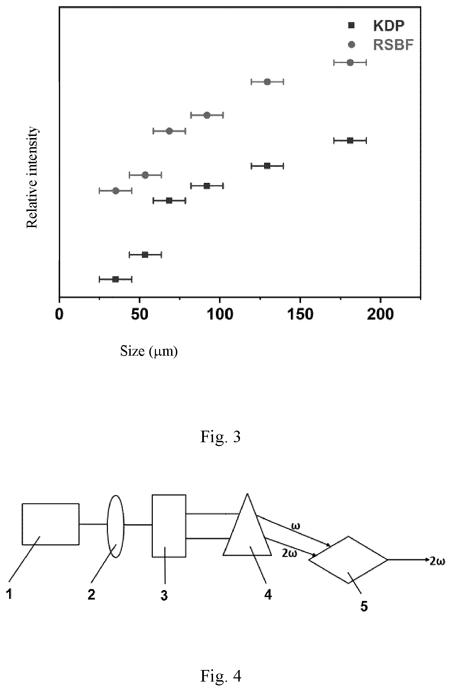

Fig. 3 is a schematic diagram of the SHG effect of the Rb₂ScB₃O₆F₂ nonlinear optical crystal of the present invention in different particle size ranges. Within the particle size range of 150-212 µm, the Rb₂ScB₃O₆F₂ exhibits a significant nonlinear optical response, approximately 1.4 times that of KDP.
Fig. 4 shows the working principle of the nonlinear optical device made of the Rb₂ScB₃O₆F₂ nonlinear optical crystal of the present invention, wherein: 1 is a laser device, 2 is an emitting beam, 3 is a Rb₂ScB₃O₆F₂ nonlinear optical crystal after crystal post-processing and optical processing, 4 is a beam, 5 is a filter.

### DETAILED DESCRIPTION OF THE INVENTION

In order to make the content of the present invention easier to understand, the following provides a detailed explanation on the present invention in conjunction with the accompanying drawings and examples. The raw materials or equipment used in the present invention are commercially available unless otherwise specified.

### Example 1. Preparation of Rb₂ScB₃O₆F₂ compound adopting a high-temperature vacuum packaging method

According to the chemical reaction formula 2RbF+0.5Sc₂O₃+1.5B₂O₃ *=* Rb₂ScB₃O₆F₂, the Rb₂ScB₃O₆F₂ compound is prepared by adopting a high-temperature vacuum packaging method. The specific steps are as follows:
A total of 0.5 g of RbF, Sc₂O₃, and B₂O₃ as source materials in a molar ratio of 2:0.5:1.5 was weighed respectively. After being mixed uniformly, the mixture was placed in a clean graphite crucible. Then the graphite crucible was placed in a quartz tube with a length of 24 cm and a diameter of 12 mm. After evacuating the quartz tube by using a vacuum pump to a vacuum degree of 10⁻³ Pa, melting and sealing were perfomed. Then the sealed quartz tube was placed in a program-controlled muffle furnace and was heated to 650°C at a rate of 20°C/h and kept at the temperature for 33 hours, and then cooled to 520°C at a rate of 1°C/h, and finally cooled to room temperature within 3 days, the Rb₂ScB₃O₆F₂ compound of the present invention was obtained.

### Example 2. Preparation of Rb₂ScB₃O₆F₂ compound adopting a high-temperature vacuum packaging method

According to the chemical reaction formula RbF+RbBF₄+0.5Sc₂O₃+1.5B₂O₃ *=* Rb₂ScB₃O₆F₂+BF₃↑, the Rb₂ScB₃O₆F₂ compound is prepared by adopting a high-temperature vacuum packaging method. The specific steps are as follows:
A total of 0.5 g of RbF, RbBF₄, Sc₂O₃, and B₂O₃ as source materials in a molar ratio of 1:1:0.5:1.5 was weighed respectively. After being mixed uniformly, the mixture was placed in a clean graphite crucible. Then the graphite crucible was placed in a quartz tube with a length of 24 cm and a diameter of 12 mm. After evacuating the quartz tube by using a vacuum pump to a vacuum degree of 10⁻³ Pa, melting and sealing were perfomed. Then the sealed quartz tube was placed in a program-controlled muffle furnace and was heated to 670°C at a rate of 20°C/h and kept at the temperature for 32 hours, and then cooled to 510°C at a rate of 1°C/h, and finally cooled to room temperature within 3 days, the Rb₂ScB₃O₆F₂ compound of the present invention was obtained.

### Example 3. Preparation of Rb₂ScB₃O₆F₂ compound adopting a high-temperature vacuum packaging method

According to the chemical reaction formula 2RbF+Sc(NO₃)₃+1.5B₂O₃ *=* Rb₂ScB₃O₆F₂+3NO₂↑+0.750₂↑, the Rb₂ScB₃O₆F₂ compound is prepared by adopting a high-temperature vacuum packaging method. The specific steps are as follows:
A total of 0.5 g of RbF, Sc(NO₃)₃, and B₂O₃ as source materials in a molar ratio of 2:1:1.5 was weighed respectively. After being mixed uniformly, the mixture was placed in a clean graphite crucible. Then the graphite crucible was placed in a quartz tube with a length of 24 cm and a diameter of 12 mm. After evacuating the quartz tube by using a vacuum pump to a vacuum degree of 10⁻³ Pa, melting and sealing were perfomed. Then the sealed quartz tube was placed in a program-controlled muffle furnace and was heated to 650°C at a rate of 20°C/h and kept at the temperature for 31 hours, and then cooled to 400°C at a rate of 1°C/h, and finally cooled to room temperature within 3 days, the Rb₂ScB₃O₆F₂ compound of the present invention was obtained.

### Example 4. Preparation of Rb₂ScB₃O₆F₂ compound adopting a high-temperature vacuum packaging method

According to the chemical reaction formula 2RbF+0.5Sc₂O₃+1.5B₂O₃ *=* Rb₂ScB₃O₆F₂, the Rb₂ScB₃O₆F₂ compound is prepared by adopting a high-temperature vacuum packaging method. The specific steps are as follows:
A total of 0.5 g of RbF, Sc₂O₃ and B₂O₃ as source materials in a molar ratio of 2:0.5:2.5 was weighed respectively. After being mixed uniformly, the mixture was placed in a clean graphite crucible. Then the graphite crucible was placed in a quartz tube with a length of 24 cm and a diameter of 12 mm. After evacuating the quartz tube by using a vacuum pump to a vacuum degree of 10⁻³ Pa, melting and sealing were perfomed. Then the sealed quartz tube was placed in a program-controlled muffle furnace and was heated to 680°C at a rate of 20°C/h and kept at the temperature for 33 hours, and then cooled to 450°C at a rate of 1°C/h, and finally cooled to room temperature within 2 days, the Rb₂ScB₃O₆F₂ compound of the present invention was obtained.

### Example 5. Preparation of Rb₂ScB₃O₆F₂ compound adopting a high-temperature vacuum packaging method

According to the chemical reaction formula 2Rb₂CO₃+2ScF₃+3B₂O₃ *=* 2Rb₂ScB₃O₆F₂+3F₂↑+CO↑+CO₂↑, the Rb₂ScB₃O₆F₂ compound is prepared by adopting a high-temperature vacuum packaging method. The specific steps are as follows:
A total of 0.5 g of Rb₂CO₃, ScF₃ and B₂O₃ as source materials in a molar ratio of 1:1:2 was weighed respectively. After being mixed uniformly, the mixture was placed in a clean graphite crucible. Then the graphite crucible was placed in a quartz tube with a length of 24 cm and a diameter of 12 mm. After evacuating the quartz tube by using a vacuum pump to a vacuum degree of 10⁻³ Pa, melting and sealing were perfomed. Then the sealed quartz tube was placed in a program-controlled muffle furnace and was heated to 680°C at a rate of 20°C/h and kept at the temperature for 30 hours, and then cooled to 480°C at a rate of 1°C/h, and finally cooled to room temperature within 2 days, the Rb₂ScB₃O₆F₂ compound of the present invention was obtained.

### Example 6. Preparation of Rb₂ScB₃O₆F₂ compound adopting a high-temperature vacuum packaging method

According to the chemical reaction formula 4RbNO₃+2ScF₃+3B₂O₃ *=* 2Rb₂ScB₃O₆F₂+F₂↑+4NO₂↑+0.5O₂↑, the Rb₂ScB₃O₆F₂ compound is prepared by adopting a high-temperature vacuum packaging method. The specific steps are as follows:
A total of 0.5 g of RbNO₃, ScF₃ and B₂O₃ as source materials in a molar ratio of 2:1:2 was weighed respectively. After being mixed uniformly, the mixture was placed in a clean graphite crucible. Then the graphite crucible was placed in a quartz tube with a length of 24 cm and a diameter of 12 mm. After evacuating the quartz tube by using a vacuum pump to a vacuum degree of 10⁻³ Pa, melting and sealing were perfomed. Then the sealed quartz tube was placed in a program-controlled muffle furnace and was heated to 650°C at a rate of 20°C/h and kept at the temperature for 30 hours, and then cooled to 400°C at a rate of 1°C/h, and finally cooled to room temperature within 2 days, the Rb₂ScB₃O₆F₂ compound of the present invention was obtained.

### Example 7. Preparation of Rb₂ScB₃O₆F₂ compound adopting a high-temperature vacuum packaging method

According to the chemical reaction formula 2RbF+ScF₃+2B₂O₃ *=* Rb₂ScB₃O₆F₂+BF₃↑, the Rb₂ScB₃O₆F₂ compound is prepared by adopting a high-temperature vacuum packaging method. The specific steps are as follows:
A total of 0.5 g of RbF, ScF₃ and B₂O₃ as source materials in a molar ratio of 2:1:2.5 was weighed respectively. After being mixed uniformly, the mixture was placed in a clean graphite crucible. Then the graphite crucible was placed in a quartz tube with a length of 24 cm and a diameter of 12 mm. After evacuating the quartz tube by using a vacuum pump to a vacuum degree of 10⁻³ Pa, melting and sealing were perfomed. Then the sealed quartz tube was placed in a program-controlled muffle furnace and was heated to 670°C at a rate of 20°C/h and kept at the temperature for 28 hours, and then cooled to 470°C at a rate of 1°C/h, and finally cooled to room temperature within 2 days, the Rb₂ScB₃O₆F₂ compound of the present invention was obtained.

### Example 8. Preparation of Rb₂ScB₃O₆F₂ compound adopting a high-temperature vacuum packaging method

According to the chemical reaction formula 2RbF+ScF₃+2B₂O₃ *=* Rb₂ScB₃O₆F₂+BF₃↑, the Rb₂ScB₃O₆F₂ compound is prepared by adopting a high-temperature vacuum packaging method. The specific steps are as follows:
A total of 0.5 g of RbF, ScF₃ and B₂O₃ as source materials in a molar ratio of 2:1:2 was weighed respectively. After being mixed uniformly, the mixture was placed in a clean graphite crucible. Then the graphite crucible was placed in a quartz tube with a length of 24 cm and a diameter of 12 mm. After evacuating the quartz tube by using a vacuum pump to a vacuum degree of 10⁻³ Pa, melting and sealing were perfomed. Then the sealed quartz tube was placed in a program-controlled muffle furnace and was heated to 680°C at a rate of 20°C/h and kept at the temperature for 32 hours, and then cooled to 480°C at a rate of 1°C/h, and finally cooled to room temperature within 2 days, the Rb₂ScB₃O₆F₂ compound of the present invention was obtained.

### Example 9. Preparation of Rb₂ScB₃O₆F₂ compound adopting a solid-state synthesis method

According to the chemical reaction formula 2RbF+0.5Sc₂O₃+1.5B₂O₃ *=* Rb₂ScB₃O₆F₂, the Rb₂ScB₃O₆F₂ compound is prepared by adopting a solid-state synthesis method. The specific steps are as follows:
A total of 5 g of RbF, Sc₂O₃ and B₂O₃ as source materials in a molar ratio of 2:0.5:1.5 was weighed respectively and mixed. The mixture was placed in a clean corundum mortar and ground for 1 hour, then the mixed raw materials are pressed into a sheet-like sample with a diameter of 2 cm through a die. Thereafter, the sheet-like sample was placed in a corundum crucible with a diameter of 5 cm. The corundum crucible was placed in a program-controlled single crystal growth furnace, and was heated to 660°C at a rate of 25°C/h for solid-state reaction and kept at the temperature for 3 days. During the days, the corundum crucible was taked out and the sample was ground 3 times for half an hour each time, followed by powder XRD testing. Until the measured powder XRD was consistent with its theoretical value, the sample was placed in the single crystal growth furnace at 660°C for 5 days, and finally cooled to room temperature at a rate of 20°C/day, the polycrystalline powder Rb₂ScB₃O₆F₂ compound of the present invention was obtained.

### Example 10. Preparation of Rb₂ScB₃O₆F₂ compound adopting a solid-state synthesis method

According to the chemical reaction formula RbF+RbBF₄+0.5Sc₂O₃+1.5B₂O₃ *=* Rb₂ScB₃O₆F₂+BF₃↑, the Rb₂ScB₃O₆F₂ compound is prepared by adopting a solid-state synthesis method. The specific steps are as follows:
A total of 5 g of RbF, RbBF₄, Sc₂O₃ and B₂O₃ as source materials in a molar ratio of 1:1:0.5:1.5 was weighed respectively and mixed. The mixture was placed in a clean corundum mortar and ground for 1 hour, then the mixed raw materials are pressed into a sheet-like sample with a diameter of 2 cm through a die. Thereafter, the sheet-like sample was placed in a corundum crucible with a diameter of 5 cm. The corundum crucible was placed in a program-controlled single crystal growth furnace, and was heated to 650°C at a rate of 25°C/h for solid-state reaction and kept at the temperature for 5 days. During the days, the corundum crucible was taked out and the sample was ground 3 times for half an hour each time, followed by powder XRD testing. Until the measured powder XRD was consistent with its theoretical value, the sample was placed in the single crystal growth furnace at 650°C for 4 days, and finally cooled to room temperature at a rate of 20°C/day, the polycrystalline powder Rb₂ScB₃O₆F₂ compound of the present invention was obtained.

### Example 11. Preparation of Rb₂ScB₃O₆F₂ compound adopting a solid-state synthesis method

According to the chemical reaction formula 2RbF+ScF₃+2B₂O₃ *=* Rb₂ScB₃O₆F₂+BF₃↑, the Rb₂ScB₃O₆F₂ compound is prepared by adopting a solid-state synthesis method. The specific steps are as follows:
A total of 10 g of RbF, ScF₃ and B₂O₃ as source materials in a molar ratio of 2:1:2 was weighed respectively and mixed. The mixture was placed in a clean corundum mortar and ground for 1 hour, then the mixed raw materials are pressed into a sheet-like sample with a diameter of 2 cm through a die. Thereafter, the sheet-like sample was placed in a corundum crucible with a diameter of 10 cm. The corundum crucible was placed in a program-controlled single crystal growth furnace, and was heated to 670°C at a rate of 28°C/h for solid-state reaction and kept at the temperature for 3 days. During the days, the corundum crucible was taked out and the sample was ground 3 times for half an hour each time, followed by powder XRD testing. Until the measured powder XRD was consistent with its theoretical value, the sample was placed in the single crystal growth furnace at 670°C for 10 days, and finally cooled to room temperature at a rate of 20°C/day, the polycrystalline powder Rb₂ScB₃O₆F₂ compound of the present invention was obtained.

### Example 12. Preparation of Rb₂ScB₃O₆F₂ compound adopting a solid-state synthesis method

According to the chemical reaction formula 2RbF+Sc(NO₃)₃+3H₃BO₃ *=* Rb₂ScB₃O₆F₂+3NO₂↑+4.5H₂O↑+0.75O₂↑, the Rb₂ScB₃O₆F₂ compound is prepared by adopting a solid-state synthesis method. The specific steps are as follows:
A total of 3 g of RbF, Sc(NO₃)₃ and H₃BO₃ as source materials in a molar ratio of 2:1:3 was weighed respectively and mixed. The mixture was placed in a clean corundum mortar and ground for 1 hour, then the mixed raw materials are pressed into a sheet-like sample with a diameter of 2 cm through a die. Thereafter, the sheet-like sample was placed in a corundum crucible with a diameter of 5 cm. The corundum crucible was placed in a program-controlled single crystal growth furnace, and was heated to 650°C at a rate of 20°C/h for solid-state reaction and kept at the temperature for 5 days. During the days, the corundum crucible was taked out and the sample was ground 4 times for half an hour each time, followed by powder XRD testing. Until the measured powder XRD was consistent with its theoretical value, the sample was placed in the single crystal growth furnace at 650°C for 5 days, and finally cooled to room temperature at a rate of 20°C/day, the polycrystalline powder Rb₂ScB₃O₆F₂ compound of the present invention was obtained.

### Example 13. Preparation of Rb₂ScB₃O₆F₂ compound adopting a solid-state synthesis method

According to the chemical reaction formula 4RbNO₃+2ScF₃+6H₃BO₃ *=* 2Rb₂ScB₃O₆F₂+F₂↑+9H₂O↑+4NO₂↑+0.5O₂↑, the Rb₂ScB₃O₆F₂ compound is prepared by adopting a solid-state synthesis method. The specific steps are as follows:
A total of 7 g of RbNO₃, ScF₃ and H₃BO₃ as source materials in a molar ratio of 4:2:6 was weighed respectively and mixed. The mixture was placed in a clean corundum mortar and ground for 1 hour, then the mixed raw materials are pressed into a sheet-like sample with a diameter of 2 cm through a die. Thereafter, the sheet-like sample was placed in a corundum crucible with a diameter of 10 cm. The corundum crucible was placed in a program-controlled single crystal growth furnace, and was heated to 670°C at a rate of 24°C/h for solid-state reaction and kept at the temperature for 5 days. During the days, the corundum crucible was taked out and the sample was ground 4 times for half an hour each time, followed by powder XRD testing. Until the measured powder XRD was consistent with its theoretical value, the sample was placed in the single crystal growth furnace at 670°C for 6 days, and finally cooled to room temperature at a rate of 20°C/day, the polycrystalline powder Rb₂ScB₃O₆F₂ compound of the present invention was obtained.

### Example 14. Preparation of Rb₂ScB₃O₆F₂ compound adopting a solid-state synthesis method

According to the chemical reaction formula Rb₂CO₃+ScF₃+3H₃BO₃ *=* Rb₂ScB₃O₆F₂+HF↑+4H₂O↑+CO₂↑, the Rb₂ScB₃O₆F₂ compound is prepared by adopting a solid-state synthesis method. The specific steps are as follows:
A total of 10 g of Rb₂CO₃, ScF₃ and H₃BO₃ as source materials in a molar ratio of 1:1:3 was weighed respectively and mixed. The mixture was placed in a clean corundum mortar and ground for 1 hour, then the mixed raw materials are pressed into a sheet-like sample with a diameter of 2 cm through a die. Thereafter, the sheet-like sample was placed in a corundum crucible with a diameter of 10 cm. The corundum crucible was placed in a program-controlled single crystal growth furnace, and was heated to 660°C at a rate of 20°C/h for solid-state reaction and kept at the temperature for 4 days. During the days, the corundum crucible was taked out and the sample was ground 4 times for half an hour each time, followed by powder XRD testing. Until the measured powder XRD was consistent with its theoretical value, the sample was placed in the single crystal growth furnace at 660°C for 10 days, and finally cooled to room temperature at a rate of 20°C/day, the polycrystalline powder Rb₂ScB₃O₆F₂ compound of the present invention was obtained.

### Example 15. Preparation of Rb₂ScB₃O₆F₂ nonlinear optical crystal adopting a fluxing agent method

The Rb₂ScB₃O₆F₂ nonlinear optical crystal is prepared by adopting a fluxing agent method. The specific steps are as follows:
a. A total of 10 g of the polycrystalline powder Rb₂ScB₃O₆F₂ compound obtained in Example 9 and a fluxing agent PbO in a molar ratio of 1:2 was weighed respectively and mixed. The mixture was placed in an open platinum crucible with a diameter of 40 mm × 50 mm. Then the platinum crucible was placed in a program-controlled single crystal growth furnace, and was heated to 850°C at a rate of 50°C/h and kept at the temperature for 24 hours, and then cooled to 780°C at a rate of 1°C/h, a mixed melt was obtained;
b. The mixed melt was slowly cooled to room temperature at a rate of 0.5°C/h to obtain seed crystals;
c. The seed crystal was fixed onto a seed crystal rod and feeded from the top of the single crystal growth furnace to make it contact with the surface of the mixed melt obtained from the step *a*. The mixed melt was left at 780°C for 10 mins, then was cooled to 710°C at a rate of 0.5°C/h, and the seed crystal rod was rotated at a speed of 7 rpm. A crystal was taked out from the surface of the mixed melt if the crystal grows to the desired size, and cooled to room temperature at a rate of 20°C/h. Finally, the crystal was taked out from the single crystal growth furnace to obtain the Rb₂ScB₃O₆F₂ nonlinear optical crystal with a size of 5 mm × 3 mm × 4 mm.

### Example 16. Preparation of Rb₂ScB₃O₆F₂ nonlinear optical crystal adopting a fluxing agent method

The Rb₂ScB₃O₆F₂ nonlinear optical crystal is prepared by adopting a fluxing agent method. The specific steps are as follows:
a. A total of 10 g of the polycrystalline powder Rb₂ScB₃O₆F₂ compound obtained in Example 10 and a fluxing agent LiF in a molar ratio of 1:10 was weighed respectively and mixed. The mixture was placed in an open platinum crucible with a diameter of 40 mm × 50 mm. Then the platinum crucible was placed in a program-controlled single crystal growth furnace, and was heated to 830°C at a rate of 50°C/h and kept at the temperature for 30 hours, and then cooled to 750°C at a rate of 1.5 °C/h, a mixed melt was obtained;
b. The mixed melt was slowly cooled to room temperature at a rate of 1°C/h to obtain seed crystals;
c. The seed crystal was fixed onto a seed crystal rod and feeded from the top of the single crystal growth furnace to make it contact with the surface of the mixed melt obtained from the step *a*. The mixed melt was left at 750°C for 10 mins, then was cooled to 700°C at a rate of 0.8°C/h, and the seed crystal rod was rotated at a speed of 6.5 rpm. A crystal was taked out from the surface of the mixed melt if the crystal grows to the desired size, and cooled to room temperature at a rate of 20°C/h. Finally, the crystal was taked out from the single crystal growth furnace to obtain the Rb₂ScB₃O₆F₂ nonlinear optical crystal with a size of 4 mm × 3 mm × 2 mm.

### Example 17. Preparation of Rb₂ScB₃O₆F₂ nonlinear optical crystal adopting a fluxing agent method

The Rb₂ScB₃O₆F₂ nonlinear optical crystal is prepared by adopting a fluxing agent method. The specific steps are as follows:
a. A total of 12 g of the polycrystalline powder Rb₂ScB₃O₆F₂ compound obtained in Example 11 and a fluxing agent (PbF₂ and PbO in morlar ration of 1:1) in a molar ratio of 1:4 was weighed respectively and mixed. The mixture was placed in an open platinum crucible with a diameter of 40 mm × 50 mm. Then the platinum crucible was placed in a program-controlled single crystal growth furnace, and was heated to 780°C at a rate of 50°C/h and kept at the temperature for 42 hours, and then cooled to 730°C at a rate of 2°C/h, a mixed melt was obtained;
b. The mixed melt was slowly cooled to room temperature at a rate of 3°C/h to obtain seed crystals;
c. The seed crystal was fixed onto a seed crystal rod and feeded from the top of the single crystal growth furnace to make it contact with the surface of the mixed melt obtained from the step *a*. The mixed melt was left at 730°C for 10 mins, then was cooled to 710°C at a rate of 1°C/h, and the seed crystal rod was rotated at a speed of 7 rpm. A crystal was taked out from the surface of the mixed melt if the crystal grows to the desired size, and cooled to room temperature at a rate of 20°C/h. Finally, the crystal was taked out from the single crystal growth furnace to obtain the Rb₂ScB₃O₆F₂ nonlinear optical crystal with a size of 5 mm × 4 mm × 2 mm.

### Example 18. Preparation of Rb₂ScB₃O₆F₂ nonlinear optical crystal adopting a fluxing agent method

The Rb₂ScB₃O₆F₂ nonlinear optical crystal is prepared by adopting a fluxing agent method. The specific steps are as follows:
a. A total of 8 g of Rb₂CO₃, ScF₃, B₂O₃ and a fluxing agent PbO in a molar ratio of 1:1:1.5:2 was weighed respectively and mixed. The mixture was placed in an open platinum crucible with a diameter of 40 mm × 50 mm. Then the platinum crucible was placed in a program-controlled single crystal growth furnace, and was heated to 850°C at a rate of 50°C/h and kept at the temperature for 24 hours, and then cooled to 780°C at a rate of 1°C/h, a mixed melt was obtained;
b. The mixed melt was slowly cooled to room temperature at a rate of 0.5°C/h to obtain seed crystals;
c. The seed crystal was fixed onto a seed crystal rod and feeded from the top of the single crystal growth furnace to make it contact with the surface of the mixed melt obtained from the step *a*. The mixed melt was left at 780°C for 10 mins, then was cooled to 710°C at a rate of 0.8°C/h, and the seed crystal rod was rotated at a speed of 5 rpm. A crystal was taked out from the surface of the mixed melt if the crystal grows to the desired size, and cooled to room temperature at a rate of 20°C/h. Finally, the crystal was taked out from the single crystal growth furnace to obtain the Rb₂ScB₃O₆F₂ nonlinear optical crystal with a size of 2 mm × 3 mm × 3.5 mm.

### Example 19. Preparation of Rb₂ScB₃O₆F₂ nonlinear optical crystal adopting a fluxing agent method

The Rb₂ScB₃O₆F₂ nonlinear optical crystal is prepared by adopting a fluxing agent method. The specific steps are as follows:
a. A total of 8 g of RbF, RbBF₄, Sc₂O₃, H₃BO₃ and a fluxing agent (PbF₂ and PbO in morlar ration of 1:1) in a molar ratio of 1:1:0.5:3:4 was weighed respectively and mixed. The mixture was placed in an open platinum crucible with a diameter of 40 mm × 50 mm. Then the platinum crucible was placed in a program-controlled single crystal growth furnace, and was heated to 780°C at a rate of 50°C/h and kept at the temperature for 42 hours, and then cooled to 730°C at a rate of 2°C/h, a mixed melt was obtained;
b. The mixed melt was slowly cooled to room temperature at a rate of 0.5°C/h to obtain seed crystals;
c. The seed crystal was fixed onto a seed crystal rod and feeded from the top of the single crystal growth furnace to make it contact with the surface of the mixed melt obtained from the step *a*. The mixed melt was left at 730°C for 10 mins, then was cooled to 710°C at a rate of 0.5°C/h, and the seed crystal rod was rotated at a speed of 5.5 rpm. A crystal was taked out from the surface of the mixed melt if the crystal grows to the desired size, and cooled to room temperature at a rate of 20°C/h. Finally, the crystal was taked out from the single crystal growth furnace to obtain the Rb₂ScB₃O₆F₂ nonlinear optical crystal with a size of 3 mm × 3.5 mm × 2 mm.

### Example 20. Preparation of Rb₂ScB₃O₆F₂ nonlinear optical crystal adopting a fluxing agent method

The Rb₂ScB₃O₆F₂ nonlinear optical crystal is prepared by adopting a fluxing agent method. The specific steps are as follows:
A total of 5 g of the polycrystalline powder Rb₂ScB₃O₆F₂ compound obtained in Example 12 and a fluxing agent (RbCl and CsF in morlar ration of 1:1) in a molar ratio of 1:6 was weighed respectively and mixed. The mixture was placed in a platinum crucible with flanged seal with a diameter of 20 mm × 50 mm. Then the platinum crucible was placed in a program-controlled single crystal growth furnace, and was heated to 680°C at a rate of 20°C/h and kept at the temperature for 72 hours, and then cooled to 480°C at a rate of 20°C/day, and futher cooled to room temperature within 2 days. Finally, the platinum crucible with flanged seal was opened, and the Rb₂ScB₃O₆F₂ nonlinear optical crystal with a size of 5 mm × 6 mm × 3 mm was obtained.

### Example 21. Preparation of Rb₂ScB₃O₆F₂ nonlinear optical crystal adopting a fluxing agent method

The Rb₂ScB₃O₆F₂ nonlinear optical crystal is prepared by adopting a fluxing agent method. The specific steps are as follows:
A total of 5 g of the polycrystalline powder Rb₂ScB₃O₆F₂ compound obtained in Example 13 and a fluxing agent (RbF and RbCl in morlar ration of 1:1) in a molar ratio of 1:3 was weighed respectively and mixed. The mixture was placed in a platinum crucible with flanged seal with a diameter of 20 mm × 50 mm. Then the platinum crucible was placed in a program-controlled single crystal growth furnace, and was heated to 720°C at a rate of 20°C/h and kept at the temperature for 72 hours, and then cooled to 400°C at a rate of 20°C/day, and futher cooled to room temperature within 1 days. Finally, the platinum crucible with flanged seal was opened, and the Rb₂ScB₃O₆F₂ nonlinear optical crystal with a size of 3 mm × 3 mm × 4 mm was obtained.

### Example 22. Preparation of Rb₂ScB₃O₆F₂ nonlinear optical crystal adopting a fluxing agent method

The Rb₂ScB₃O₆F₂ nonlinear optical crystal is prepared by adopting a fluxing agent method. The specific steps are as follows:
A total of 4 g of the polycrystalline powder Rb₂ScB₃O₆F₂ compound obtained in Example 14 and a fluxing agent (RbCl and CsF in morlar ration of 1:1) in a molar ratio of 1:1 was weighed respectively and mixed. The mixture was placed in a platinum crucible with flanged seal with a diameter of 20 mm × 50 mm. Then the platinum crucible was placed in a program-controlled single crystal growth furnace, and was heated to 680°C at a rate of 5°C/h and kept at the temperature for 72 hours, and then cooled to 480°C at a rate of 20°C/day, and futher cooled to room temperature within 2 days. Finally, the platinum crucible with flanged seal was opened, and the Rb₂ScB₃O₆F₂ nonlinear optical crystal with a size of 3 mm × 3.5 mm × 3 mm was obtained.

### Example 23. Preparation of Rb₂ScB₃O₆F₂ nonlinear optical crystal adopting a fluxing agent method

The Rb₂ScB₃O₆F₂ nonlinear optical crystal is prepared by adopting a fluxing agent method. The specific steps are as follows:
A total of 3 g of RbF, Sc(NO₃)₃, B₂O₃ and a fluxing agent MoO₃ in a molar ratio of 2:1:3:3 was weighed respectively and mixed. The mixture was placed in a platinum crucible with flanged seal with a diameter of 20 mm × 50 mm. Then the platinum crucible was placed in a program-controlled single crystal growth furnace, and was heated to 680°C at a rate of 20°C/h and kept at the temperature for 72 hours, and then cooled to 400°C at a rate of 20°C/day, and futher cooled to room temperature within 1 days. Finally, the platinum crucible with flanged seal was opened, and the Rb₂ScB₃O₆F₂ nonlinear optical crystal with a size of 2.5 mm × 3 mm × 2 mm was obtained.

### Example 24. Preparation of Rb₂ScB₃O₆F₂ nonlinear optical crystal adopting a fluxing agent method

The Rb₂ScB₃O₆F₂ nonlinear optical crystal is prepared by adopting a fluxing agent method. The specific steps are as follows:
A total of 3 g of RbNO₃, ScF₃, B₂O₃ and a fluxing agent (RbF and PbO in morlar ration of 3:1) in a molar ratio of 4:2:6:1 was weighed respectively and mixed. The mixture was placed in a platinum crucible with flanged seal with a diameter of 20 mm × 50 mm. Then the platinum crucible was placed in a program-controlled single crystal growth furnace, and was heated to 690°C at a rate of 10°C/h and kept at the temperature for 72 hours, and then cooled to 450°C at a rate of 20°C/day, and futher cooled to room temperature within 2 days. Finally, the platinum crucible with flanged seal was opened, and the Rb₂ScB₃O₆F₂ nonlinear optical crystal with a size of 4 mm × 3 mm × 3 mm was obtained.

### Example 25. Preparation of Rb₂ScB₃O₆F₂ nonlinear optical crystal adopting a fluxing agent method

The Rb₂ScB₃O₆F₂ nonlinear optical crystal is prepared by adopting a fluxing agent method. The specific steps are as follows:
A total of 4 g of RbF, Sc₂O₃, B₂O₃ and a fluxing agent (RbF and PbO in morlar ration of 3: 1) in a molar ratio of 2:0.5:1.5:1 was weighed respectively and mixed. The mixture was placed in a platinum crucible with flanged seal with a diameter of 20 mm × 50 mm. Then the platinum crucible was placed in a program-controlled single crystal growth furnace, and was heated to 720°C at a rate of 5°C/h and kept at the temperature for 72 hours, and then cooled to 480°C at a rate of 20°C/day, and futher cooled to room temperature within 2 days. Finally, the platinum crucible with flanged seal was opened, and the Rb₂ScB₃O₆F₂ nonlinear optical crystal with a size of 2 mm × 3.5 mm × 2.5 mm was obtained.

### Example 26. Performance of nonlinear optical crystals

The Performances of the Rb₂ScB₃O₆F₂ nonlinear optical crystals prepared in Examples 15-25 are tested.

It can be seen that the Rb₂ScB₃O₆F₂ nonlinear optical crystals of the present invention belong to the monoclinic crystal system, the space group thereof is *P*2₁, and the nonlinear optical crystals do not have a center of symmetry, and the unit cell parameters thereof are: *a* = 4.0372(10) Å, *b =* 11.800(3) Å, *c* = 8.823(2) A, a = *γ* = 90°, *β* = 98.327(11) °, Z = 2.

Fig. 1 shows the XRD pattern of the polycrystalline powder Rb₂ScB₃O₆F₂ prepared in Example 9 of the present invention, as well as the simulated XRD pattern based on the crystal structure of Rb₂ScB₃O₆F₂.

Fig. 2 is a schematic diagram of the structure of the Rb₂ScB₃O₆F₂ nonlinear optical crystal of the present invention, in which (a) the basic building groups, (b) the connection between the groups [ScO₃F₃] and [B₃O₆], (c) the arrangement of the groups [B₃O₆] observed from the c-axis, and (d) the overall structure of Rb₂ScB₃O₆F₂ observed from the c-axis, isolated groups [B₃O₆] are connected through the polyhedral of [ScO₃F₃], and Rb atoms fill the pores to balance charges and support the structure.

Fig. 3 is a schematic diagram of the SHG effect of the Rb₂ScB₃O₆F₂ nonlinear optical crystal of the present invention in different particle size ranges. Within the particle size range of 150-212 µm, the Rb₂ScB₃O₆F₂ exhibits a significant nonlinear optical response, approximately 1.4 times that of KDP.

It can be seen that the Rb₂ScB₃O₆F₂ nonlinear optical crystal of the present invention has a short absorption cutoff edge, large nonlinear optical effects, good thermal stability, and stable physical and chemical properties.

### Example 27. Application in Nonlinear Optical Devices

The Rb₂ScB₃O₆F₂ nonlinear optical crystals prepared in Examples 15-25 are not easily fragmented, not easily deliquescent, and are easy to cut, polish, process, and store.

The Rb₂ScB₃O₆F₂ crystal obtained in Example 15-25 was processed into a frequency doubling device with a size of 2 mm × 3 mm × 2 mm in the phase matching direction, and was placed at the position 3 of the nonlinear optical device shown in Fig. 4. At room temperature, Nd:YAG laser device 1 is used as the light source, and the incident wavelength is 1064 nm. The infrared beam 2 with a wavelength of 1064 nm emitted by Q-switched Nd:YAG laser device 1 enters Rb₂ScB₃O₆F₂ nonlinear optical crystal 3 and produces a green frequency doubling light with a wavelength of 532 nm. The output beam 4 contains the infrared light with a wavelength of 1064 nm and green light with a wavelength of 532 nm. The light with a wavelength of 1064 nm was filtered out by the Filter 5, and finally a green laser with a wavelength of 532 nm is obtained.

Thus, the Rb₂ScB₃O₆F₂ nonlinear optical crystal of the present invention can be used in a frequency doubling generator, up/down frequency converter, and optical parametric oscillator.

Finally, it should be noted that the above examples are only used to illustrate the technical solution of the present invention and not to limit it. Although the present invention has been described in detail with reference to the examples, those skilled in the art should understand that any modification or equivalent substitution of the technical solution of the present invention does not depart from the spirit and scope of the technical solution of the present invention, and should be included in the scope of the Claims of the present invention.

## Claims

1. A rubidium fluoro-scandium borate compound, with a chemical formula Rb₂ScB₃O₆F₂ and a molecular weight of 382.33 g/mol.

2. A method for preparing a rubidium fluoro-scandium borate compound, which adopts a high-temperature vacuum packaging method or a solid-state synthesis method.

3. The method for preparing a rubidium fluoro-scandium borate compound according to claim 2, which adopts the high-temperature vacuum packaging method, comprising the following steps:
Placing Rb source material, Sc source material, and B source material in a molar ratio of Rb:Sc:B = 2:1:3-5 in a graphite crucible, wherein the Rb source material is RbF, Rb₂CO₃, RbNO₃ or RbBF₄, the Sc source material is Sc₂O₃, ScF₃ or Sc(NO₃)₃, the B source material is B₂O₃, and at least one of the source materials is fluoride;
Placing the graphite crucible in a quartz tube, evacuating the quartz tube to a vacuum degree of 10⁻³ Pa, sealing the quartz tube at high temperature and then placing it in a muffle furnace; heating the muffle furnace at a rate of 20°C/h to 650-680°C and maintaining the temperature for 28-33 hours, then cooling it at a rate of 1°C/h to 400-520°C, and finally cooling it to room temperature within 2-3 days to obtain the desired rubidium fluoro-scandium borate compound.

4. The method for preparing a rubidium fluoro-scandium borate compound according to claim 2, which adopts the solid-state synthesis method, comprising the following steps:
Placing Rb source material, Sc source material, and B source material in a molar ratio of Rb:Sc:B = 2:1:3 in a corundum mortar, wherein the Rb source material is RbF, Rb₂CO₃, RbNO₃ or RbBF₄, the Sc source material is Sc₂O₃, ScF₃ or Sc(NO₃)₃, the B source material is B₂O₃ or H₃BO₃, and at least one of the source materials is fluoride; grinding them to mix uniformly, and then pressing them into a sheet-like sample with a diameter of 2 cm through a die;
Placing the sample in a corundum crucible with a diameter of 5-10 cm, and placing the corundum crucible in a program-controlled single crystal growth furnace, heating it at a rate of 20-28°C/h to 650-670°C for solid-state reaction and maintaining the temperature for 3-5 days; and during the days, taking out the corundum crucible and grinding the sample 3-4 times for half an hour each time, followed by powder XRD testing; until the measured powder XRD is consistent with its theoretical value, placing the sample in the single crystal growth furnace at 650-670°C for 4-10 days, and finally cooling it to room temperature at a rate of 20°C/day to obtain the desired rubidium fluoro-scandium borate compound.

5. A rubidium fluoro-scandium borate nonlinear optical crystal, **characterized in that** the crystal belongs to the monoclinic crystal system, and belongs to the non-centrosymmetric space group *P*2₁, and the unit cell parameters are: *α* = 4.0372(10) Å, *b* = 11.800(3) Å, *c* = 8.823(2) Å, *α* = *γ =* 90°, *β =* 98.327(11) °, *Z* = 2.

6. A method for preparing a rubidium fluoro-scandium borate nonlinear optical crystal, which adopts a fluxing agent method, comprising the following steps:
a. Adding the rubidium fluoro-scandium borate compound prepared by a solid-state synthesis method to a fluxing agent and placing them in an open platinum crucible with a diameter of 40 mm × 50 mm, then placing the platinum crucible in a program-controlled single crystal growth furnace, heating it at a rate of 50°C/h to 780-850°Cand maintaining the temperature for 24-42 hours, then cooling it at a rate of 1-2°C/h to 730-780°C to obtain a mixed melt, wherein the fluxing agent is PbO, LiF, or PbF₂+PbO;
b. Obtaining seed crystals by cooling the mixed melt obtained in step *a* to room temperature at a rate of 0.5-3 °C/h;
c. Fixing the seed crystal obtained in step b onto a seed crystal rod, feeding the seed crystal from the top of the single crystal growth furnace to make it contact with the surface of the mixed melt obtained in the step *a* and leaving it at 730-780°C for 10 mins; then cooling the mixed melt to 700-710°C at a rate of 0.5-1°C/h and rotating the seed crystal rod at a speed of 5-7 rpm; taking out a crystal from the surface of the mixed melt when the crystal grows to the desired size, cooling it to room temperature at a rate of 20°C/h; finally taking the crystal out from the single crystal growth furnace to obtain the desired rubidium fluoro-scandium borate nonlinear optical crystal.

7. The method for preparing a rubidium fluoro-scandium borate nonlinear optical crystal according to claim 6, wherein the step *a* can also be:
Adding Rb source material, Sc source material, and B source material to a fluxing agent and placing them in an open platinum crucible with a diameter of 40 mm × 50 mm, placing the platinum crucible in a program-controlled single crystal growth furnace, heating it at a rate of 50°C /h to 780-850°C and maintaining the temperature for 24-42 hours, then cooling it at a rate of 1-2°C/h to 730-780°C to obtain a mixed melt,
wherein the molar ratio of the Rb source material, the Sc source material, and B source material is = 2:1:3; wherein the Rb source material is RbF, Rb₂CO₃ or RbBF₄, the Sc source material is Sc₂O₃ or ScF₃, the B source material is B₂O₃ or H₃BO₃, and at least one of the source materials is fluoride;
wherein the fluxing agent is PbOor PbF₂+PbO.

8. A method for preparing a rubidium fluoro-scandium borate nonlinear optical crystal, which adopts a fluxing agent method, comprising the following steps:
Adding the rubidium fluoro-scandium borate compound prepared by a solid-state synthesis method to a fluxing agent and placing them in a platinum crucible with flanged seal with a diameter of 20 mm × 50 mm, then placing the platinum crucible in a program-controlled single crystal growth furnace, heating it at a rate of 5-20°C/h to 680-720°C and maintaining the temperature for 72 hours, then cooling it at a rate of 20°C/day to 400-480°C and futher cooling it to room temperature within 1-2 days to obtain a rubidium fluoro-scandium borate nonlinear optical crystal;
wherein the fluxing agent is RbCl+CsF, or RbF+RbCl.

9. A method for preparing a rubidium fluoro-scandium borate nonlinear optical crystal, which adopts a fluxing agent method, comprising the following steps:
Adding Rb source material, Sc source material, and B source material to a fluxing agent and placing them in a platinum crucible with flanged seal with a diameter of 20 mm × 50 mm, then placing the platinum crucible in a program-controlled single crystal growth furnace, heating it at a rate of 5-20°C/h to 680-720°C and maintaining the temperature for 72 hours, then cooling it at a rate of 20°C/day to 400-480°C and futher cooling it to room temperature within 1-2 days to obtain a rubidium fluoro-scandium borate nonlinear optical crystal;
wherein the molar ratio of the Rb source material, the Sc source material, and B source material is = 2:1:3; wherein the Rb source material is RbF or RbNO₃, the Sc source material is Sc₂O₃, ScF₃ or Sc(NO₃)₃, the B source material is B₂O₃, and at least one of the source materials is fluoride;
wherein the fluxing agent is MoO₃ or RbF+PbO.

10. The use of the rubidium fluoro-scandium borate nonlinear optical crystal according to claim 5 in a frequency doubling generator, up/down frequency converter, and optical parametric oscillator.
